Europäisches Patentamt

European Patent Office

Office européen des brevets

(11) Publication number: **0 403 862**
**A2**

# (12) EUROPEAN PATENT APPLICATION

(21) Application number: **90110449.7**

(51) Int. Cl.⁵: **H01H 43/10**

(22) Date of filing: **01.06.90**

(30) Priority: **21.06.89 IT 8343189**

(43) Date of publication of application:
**27.12.90 Bulletin 90/52**

(84) Designated Contracting States:
**DE ES FR IT**

(71) Applicant: **EATON CONTROLS SpA**
**Via Vittor Pisani 31**
**I-20124 Milano(IT)**

(72) Inventor: **De Biasi, Virgilio**
**Via Berlendis 87**
**I-32024 Castion (BL)(IT)**

(74) Representative: **Petraz, Gilberto Luigi**
**G.L.P. S.a.S. di Gilberto Petraz P.le Cavedalis**
**6/2**
**I-33100 Udine(IT)**

(54) **Printed circuit with circumferential connections.**

(57) Printed circuit for modular timed timer devices, which is positioned at the end of a cam-bearing drum and normal to the axis of rotation of that drum and comprises a contact-holder substrate and a brush-holder substrate, one or the other of these substrates being able to rotate in step and coordination with the cam-bearing drum, the printed circuit including concentric circumferential strips specialized by special functions and spaced apart by annular interspaces, contacts (11) specialized by special functions being comprised along the circumferential specialized strips, an electrical connection between the circumferential feeder strips (14) and the specialized contacts (11) being obtained circumferentially along the interspaces and radially through the specialized contacts (11) themselves.

fig.1a

fig.1b

## PRINTED CIRCUIT WITH CIRCUMFERENTIAL CONNECTIONS

This invention concerns a printed circuit with circumferential connections. To be more exact, the invention concerns a printed circuit positioned at one end of a timer drum of a modular timed timer device.

One type of modular timed timer device to which the printed circuit of this invention is fitted is shown in Fig.1 of FR-A-2.067.096.

In a timed timer device now being described there are normally fitted one or more printed circuits on a plane normal to the axis of rotation of the cam-bearing drum.

These printed circuits may be included on one or both operational faces, that is to say, a printed circuit may be present on one or both faces of the substrate. This printed circuit has the purpose of providing the required working switchings, the switchings of power being actuated by cams.

In certain cases the printed circuit serves also for the switching of low power, for instance to feed solenoid valves, metering devices, etc.

Brushes cooperate with the printed circuit, to which are applied on concentric circumferences the rates of connection by contact according to the desired sequence and combination, and the brushes are connected by rubbing on the areas of connection so as to transfer or receive current.

The known printed circuits are substantially of two basic types; a first type provides for the printed circuit to rotate and the brushes to be stationary, whereas a second type provides for the printed circuit to be stationary and the brushes to rotate.

In either case the reciprocal movement as between the brushes and the printed circuit is an intermittent movement marked by a transfer movement and a halt, this alternation being repeated between 40 and 100 or more times in one complete circle.

Where the printed circuit can rotate, the brushes are independent and one of them feeds the current, while the other brushes receive the current when they come into connection with the specific contact.

In this type each brush is connected to its own circuit, and therefore one brush is connected to the feeder circuit, whereas the other brushes are connected to specific user circuits.

Where the printed circuit is stationary, the brushes instead perform current transfer functions and are connected to one another.

There may be a plurality of lines of brushes in a system of this type, and the lines may be spaced apart advantageously as desired about a complete circle.

Moreover, whereas in the case of a rotary printed circuit of a know type one circumferential sequence of contacts cooperates with one specific brush and therefore with one specific user means, in the case of stationary printed circuits of a known type one circumferential sequence can serve different user means according to the transfer of connections which is brought about momentarily at that specific moment.

Moreover, in the case of rotary printed circuits the whole circumference includes contacts, whereas in the case of stationary printed circuits the circumference includes one or more gaps to make possible the transfer of the connections from the circumferential contacts to the user intakes.

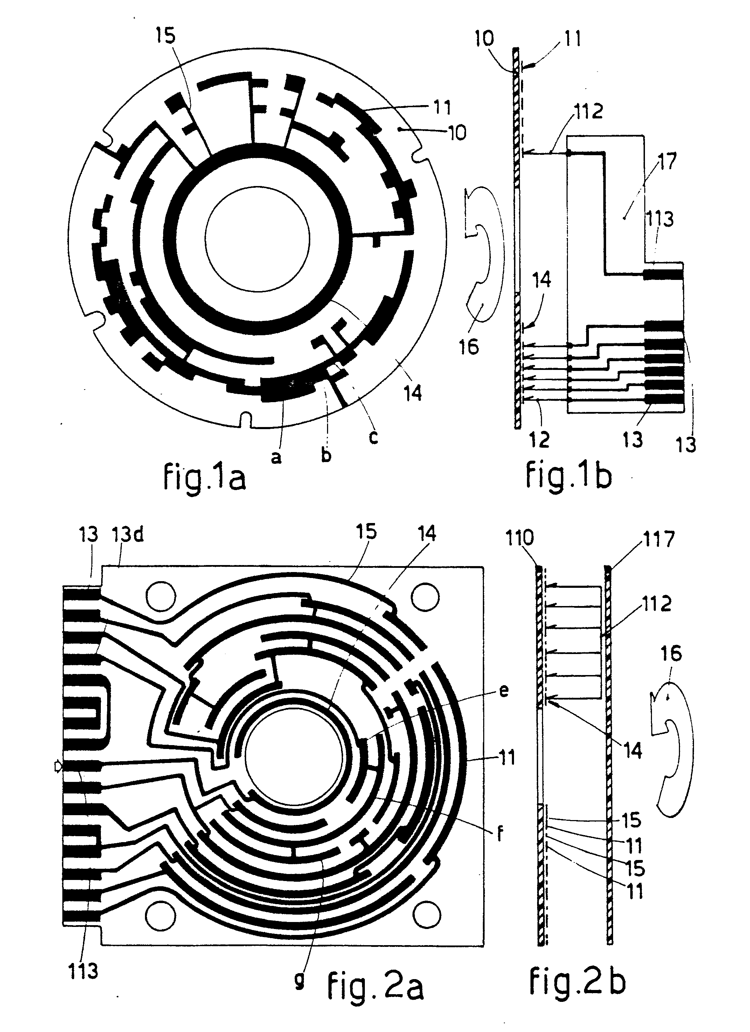

These two situations are shown in the attached Figs.1 and 2 as an example, the contacts here being positioned on one face only.

Figs.1 show a printed circuit 10 which rotates according to the arrow 16 with contacts 11, brushes 12 and connectors 13 of the user means.

The brushes 12 are fitted to stationary substrates 17 to which are applied the necessary connections between the brushes 12 and user means connectors 13.

The brushes 12 are individually specialized by specific functions, so that there is a brush 112 which takes current from a user connector 113 to a continuous circumferential contact 14 and there are brushes 12 which transfer signals of current from contacts 11 to the individual user connectors 13.

The user contacts 11 lie on concentric circumferential strips, as also does the continuous contact 14 that receives current.

The user contacts 11 lie on circumferential strips set to work according to requirements and can therefore also adjoin each other, as in the example of the strips "a", "b" and "c".

In this case, where contacts 11 correspond to each other, the transfer of current between the contacts 11 takes place by physical continuity.

Instead, where the contacts 11 do not adjoin each other, the current is transferred by means of radial connecting lines 15, which are brushed by the brushes 12 during the movement of the latter between one working position and the next one.

These radial connecting lines 15 have of necessity to be positioned in the interspace between one halted position and the next one and to take up a very modest space to prevent random connections taking place with the brushes 12 in their working position.

If this is found easy in the case of outer circumferences, it is physically much harder in the event of circumferences of a small diameter (inner circumferences), so that it is not possible to go below given diameters of circumference since the brushes 12 in their working position, owing to the summation of the tolerances, might come into contact with such radial connecting lines 15.

This system is undoubtedly good but entails the shortcoming that the contacts 11 can lie on circumferences of a considerable diameter, and this reduces the number of circumferential strips which can be used in view of the well established maximum overall dimensions permitted.

Moreover, the system imposes greater angular accuracy of a mechanical type and of design work so as to obviate undesired connections when the brushes 12 are halted in their working position.

Undesirable connections can be created readily during use as the field of tolerances is widened by wear.

Figs.2 show a stationary printed circuit 110 that cooperates with a rotary substrate 117, on which are fitted brushes 12 in one or more lines arranged at an angle to each other along the circumference and radially. These brushes 12 are connected together electrically by a connection 112 included in the rotary substrate 117.

The brushes 12 cooperate with contacts 11 arranged on spaced circumferential strips.

Connectors 15 are provided between one circumferential strip and another and are arranged partly on circumferences and partly in straight lines where they are connected to connectors 13 of the user means.

The circumferential strips do not take up a whole 360° circle but only a part thereof so as to leave a passage for the connectors 15 to arrive at the user connectors 13.

The brushes 12 transfer an electrical signal from a strip 14 fed with current (in this case the central strip) to the strip where the contact is at that specific moment and thence to the connector 13 of the specific user means.

This means that a strip is not specialized functionally for a specific user means; instead, the specific contacts 11, which may be arranged on any strip, serve specific user means; for a clearer understanding, reference should be made, for instance, to the user means 13d, which receives signals from the contacts 11 included in the strips "e", "f" and "g".

This system also is good, but it too entals various drawbacks. In fact, it involves a considerable step between one strip and another so as to leave a passage for the circumferential connectors 15. Moreover, it entails the same shortcomings as the former system when a connector 15 has of necessity to be positioned radially and to connect two strips which are not contiguous.

Next, it involves a very careful, complex examination to obtain the required connections at the required moment.

It also entails a great restriction of the portion of a full circle which can be used and therefore a further restriction of the minimum extent of the elementary conatct 11.

Thus, the above two known systems involve a plurality of drawbacks, which can hardly be adapted to the more and more sophisticated requirements of the users of such timers.

Besides a continuous demand for reduction of costs, there has been for some time now an even more urgent requirement for the supply of timers which work constantly well in the long term without increases of the tolerances caused by wear during working.

Another requirement is to achieve a greater number of circumferential strips so as to be able to govern a greater number of user means in view of the more and more sophisticated nature of the machines to which these timers are fitted.

The requirements of users include also the ability to avoid, during the transient period of movement from one working position to another, the occurrence of false signals or undesired pulses, which in the state of the art make necessary successive apparatuses to filter and select the signals.

A far from new requirement is also the provision of a greater number of contacts in a circumferential strip.

The present applicant has therefore designed and tested surprisingly this invention, which overcomes the above problems and provides a plurality of advantages which will become clear in the disclosure which follows.

A printed circuit with circumferential connections according to the invention is set forth and characterized in the main claim, while the dependent claims describe variants of the idea of the original solution.

The invention can be applied to stationary printed circuits and rotary printed circuits. To keep the description simple, we shall describe substantially the rotary printed circuits hereinafter,but to adapt the principle to stationary printed circuits it is enough to bear in mind that the latter circuits cannot take up a full 360° but have to leave a circular sector free for the passage of connections to the user connectors.

The invention provides circumferential strips specialized by specific functions and spaced apart at a preset distance of a minimum value. Such minimum value of the distance between circumferential strips is determined by the maximum intensity of the current which may pass through any part of the printed circuit.

The scope of the invention covers distances between 0.1 mm. and 0.5 mm. between one circumferential strip and another.

The circumferential strips may have a width between 0.8 mm. and 2 mm., and this width is determined substantially by the radial play which the brushes/circuit system may have, and therefore this width can also be reduced where the radial plays are more limited.

The present applicant has had successful trials with circumferential strips having a width of about 1.2 mm. and with a distance of about 0.3 mm. between two contiguous strips.

According to the invention the connections take place circumferentially by occupying the spaces between the circumferential strips.

All the contacts have only the task of transferring an equal signal to the brushes, that is to say, the contacts act as mere conductors, whereas the brushes are specialized by specific functions in coming into connection with the contacts, just as the circumferential strips on which the contacts are included are specialized by specific functions.

In this way there are no longer lateral connections, whether radial or not, which cause reductions in the lateral space which can be used for the individual elementary contact; that means that there are no radial connections of any type which might cause false signals.

The attached figures, which are given as a non-restrictive example, show the following:-

Figs.1 and 2 show the two known systems already disclosed in the state of the art;

Fig.3 shows the idea of the solution;

Figs.4 show an example of an application to a stationary printed circuit.

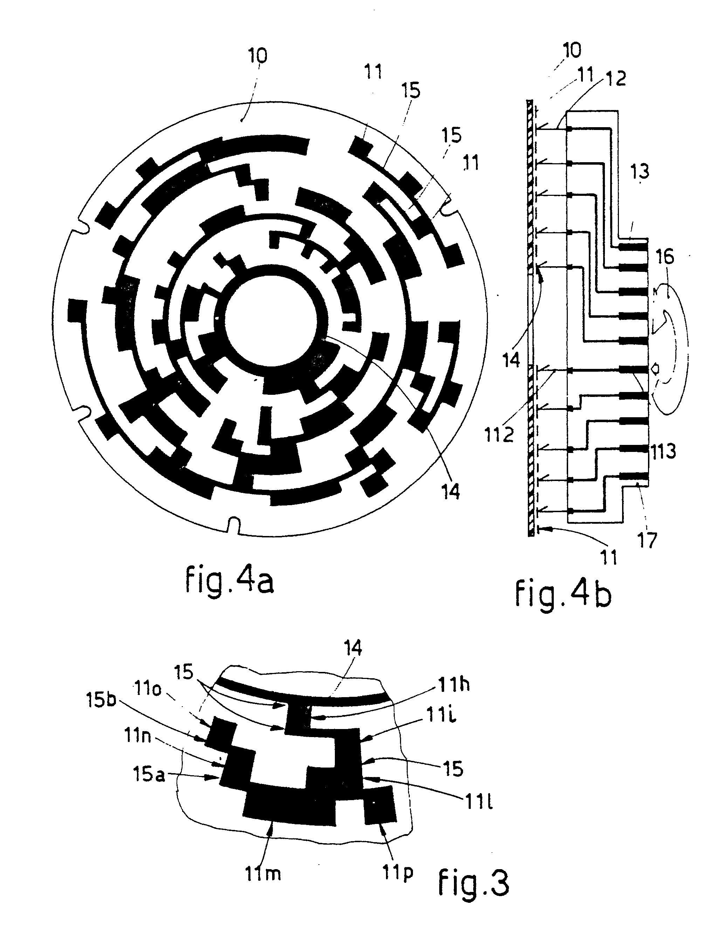

In Figs.3 and 4 a printed circuit 10 comprises about its centre a continuous circumferential strip 14 to receive electrical current from a brush 112.

The continuous circumferential strip 14 is connected to contacts 11 of the nearest strip by the filling of the interspaces therebetween, so that these interspaces become circumferential connections 15 which are obtained by filling the interspaces between one circumferential strip and another.

Thus, the electrical connection of any contact 11 to the feeder strip 14 takes place through the nearest contact 11 which may be located in the same strip, in a more outward strip or in a more inward strip.

Thus, the contact 11h is connected to the strip 14 and feeds current to the contact 11i, which feeds current to the contact 11l, which in turn feeds current through the circumferential connector 15a to the contacts 11m, 11n and 11p.

The contact 11o receives current from the contact 11n through the circumferential connector 15b.

Fig.4a shows an imaginary practical case in which all the contacts 11 are connected together electrically and are also connected to the feeder strip 14 by merely using circumferential connectors 15 provided by occupying the interspaces between circumferential strips.

Given equal usable spaces, the known embodiments of Figs.1 and 2 may be considered substantially equivalent to each other as regards the number of circumferential strips which can be obtained, whereas by means of the invention under examination it is possible to obtain a number of strips, specialized by specific functions, between twice and three times greater on each face of the printed circuit.

Likewise, the minimum lateral dimension of the elementary contact 11 can have values much more limited than is possible with the state of the art, given equal tolerances and conditions of wear.

## Claims

1 - Printed circuit for modular timed timer devices, which is positioned at the end of a cam-bearing drum and normal to the axis of rotation of that drum and comprises a contact-holder substrate and a brush-holder substrate, one or the other of these substrates being able to rotate in step and coordination with the cam-bearing drum, the printed circuit being characterized in that it includes concentric circumferential strips specialized by special functions and spaced apart by annular interspaces, contacts (11) specialized by special functions being comprised along the circumferential specialized strips, an electrical connection between the circumferential feeder strips (14) and the specialized contacts (11) being obtained circumferentially along the interspaces and radially through the specialized contacts (11) themselves.

2 - Printed circuit as claimed in Claim 1, in which each circumferential strip occupies a radial width between 0.8 mm. and 2 mm., and advantageously 1.2 mm.

3 - Printed circuit as claimed in Claim 1 or 2, in which the interspaces between one circumferential strip and another contiguous strip range from 0.1 mm. to 0.5 mm., and measure advantageously 0.3 mm.

4 - Printed circuit as claimed in any claim hereinbefore, in which the contact-holder substrate can rotate.

5 - Printed circuit as claimed in any of Claims 1 to 3 inclusive, in which the contact-holder substrate is stationary.

fig.1a

fig.1b

fig.2a

fig.2b

fig.4a

fig.4b

fig.3